# EUROPEAN PATENT APPLICATION

(11) **EP 4 760 303 A1**
(43) Date of publication of application: **17.06.2026**
(21) Application number: 25206683.2
(22) Date of filing: 03.10.2025
(51) Int. Cl.: G01R 31/389

(54) **APPARATUS AND METHOD FOR ANALYZING IMPEDANCE CHARACTERISTICS OF BATTERY, AND ENERGY STORAGE SYSTEM**

(30) Priority: 12.12.2024 KR 20240184492
(71) Applicant: SAMSUNG SDI CO., LTD., Yongin-si, Gyeonggi-do 17084 (KR)
(72) Inventor: KANG, Tae Hyeon, 16678 Suwon-si (KR); BAE, Jeong Guk, 16678 Suwon-si (KR)
(74) Representative: Marks & Clerk LLP

(57) **Abstract**

An apparatus for analyzing impedance characteristics of a battery includes: a switch configured to allow or block a current flowing along a path for supplying a charging current to a battery or extracting a discharging current from the battery; and a processor configured to derive impedance characteristics of the battery using a method of generating an excitation current for deriving the impedance characteristics of the battery from the charging current by controlling an on/off operation of the switch while the charging current for charging the battery is supplied through the path.

## Description

### BACKGROUND

### 1. Field

Aspects of the present disclosure relates to an apparatus and a method for analyzing impedance characteristics of a battery, and an energy storage system (ESS).

### 2. Description of the Related Art

An energy storage system (ESS) is a system that can store surplus electricity or power produced using new renewable energy. Idle power can be stored using an ESS during times of low electricity demand, and the power stored in the ESS can be supplied to a power grid system and consumers during times of high electricity demand so that power supply and demand can be smoothly controlled.

An ESS includes a battery serving as an energy source that stores power or extracts power, the ESS may further include a battery management system (BMS) that monitors a status of the battery and controls the battery or performs a protection operation on the basis of the monitoring result, a power conversion system (PCS) that performs AC-DC conversion and distribution functions between a power grid system and the battery, and an energy management system (EMS) that monitors an operating status of the ESS, collects and manages status data, and integrally controls the ESS. The battery includes a plurality of battery racks electrically connected to each other, each battery rack includes a plurality of battery modules electrically connected to each other, and each battery module includes a plurality of battery cells electrically connected to each other.

The above information disclosed in this Background section is for enhancement of understanding of the background of the present disclosure, and therefore, it may contain information that does not constitute related (or prior) art.

### SUMMARY

Aspects of embodiments of the present invention are directed to an apparatus and method for analyzing impedance characteristics of a battery, which are capable of improving analysis accuracy of impedance characteristics of a battery (e.g., a battery cell, a battery module, or a battery rack) applied to a battery device such as an energy storage system (ESS), and an ESS.

However, objects that the present invention intends to achieve are not limited to the above-described objects and other objects that are not described may be clearly understood by those skilled in the art from the following description.

According to some embodiments of the present invention, there is provided an apparatus for analyzing impedance characteristics of a battery, the apparatus including: a switch configured to allow or block a current flowing along a path for supplying a charging current to a battery or extracting a discharging current from the battery; and a processor configured to derive impedance characteristics of the battery using a method of generating an excitation current for deriving the impedance characteristics of the battery from the charging current by controlling an on/off operation of the switch while the charging current for charging the battery is supplied through the path.

In some embodiments, the apparatus further includes: a current detection element configured to detect the current flowing along the path, wherein the processor is configured to derive the impedance characteristics of the battery based on a voltage characteristic parameter of the battery and a current characteristic parameter of the excitation current acquired through the current detection element while the excitation current generated from the charging current is applied to the battery.

In some embodiments, the processor is configured to control the on/off operation of the switch according to a pulse width modulation (PWM) method to generate the excitation current in a form of a PWM pulse.

In some embodiments, the processor is configured to control the on/off operation of the switch to allow the excitation current to be in a frequency range.

In some embodiments, the voltage characteristic parameter represents a voltage value of the battery according to a frequency, and the current characteristic parameter represents a value of the excitation current according to the frequency; and the processor is configured to derive the impedance characteristics of the battery according to the frequency based on the voltage characteristic parameter and the current characteristic parameter.

In some embodiments, the processor is configured to derive the impedance characteristics of the battery in a form of a Nyquist diagram.

In some embodiments, the processor is configured to analyze degradation of the battery by comparing an impedance value of the battery at an analysis target frequency with a reference impedance value at the analysis target frequency.

In some embodiments, the processor is configured to control the charging of the battery by the charging current according to a constant current-constant voltage (CC-CV); and the processor is configured to derive the impedance characteristics of the battery in a CV mode.

In some embodiments, the processor is configured to control the on/off operation of the switch to generate the excitation current at a time point at which a set time elapses after the CV mode is initiated.

In some embodiments, the set time has a time length that is greater than or equal to half of a total time during which the CV mode is performed.

In some embodiments, the battery includes a plurality of battery cells; and the processor generating the excitation current is defined as a master processor, and the apparatus further includes: a slave processor configured to acquire the voltage characteristic parameter for each of the plurality of battery cells and to transmit the voltage characteristic parameter to the master processor.

In some embodiments, the master processor is configured to derive the impedance characteristics of the battery for each of the plurality of battery cells using the current characteristic parameter of the excitation current and the voltage characteristic parameter acquired for each of the plurality of battery cells.

In some embodiments, the battery is formed by connecting a plurality of battery modules including the plurality of battery cells in series, in parallel, or in a combination of series and parallel; the slave processor includes a plurality of slave processors to correspond one-to-one to the plurality of battery modules; and the master processor and the plurality of slave processors are connected in a daisy chain manner.

According to some embodiments of the present invention, there is provided an energy storage system (ESS) including: a battery; a switch configured to allow or block a current flowing along a path for supplying a charging current to a battery or extracting a discharging current from the battery; and a battery management system (BMS) configured to derive impedance characteristics of the battery using a method of generating an excitation current for deriving the impedance characteristics of the battery from the charging current by controlling an on/off operation of the switch while the charging current for charging the battery is supplied through the path.

According to some embodiments of the present invention, there is provided a method of analyzing impedance characteristics of a battery, the method including: generating, by a processor, an excitation current for deriving impedance characteristics of a battery from a charging current by controlling an on/off operation of a switch while the charging current for charging the battery is supplied through a path, wherein the path is for supplying the charging current to the battery or extracting a discharging current from the battery, and the switch allows or blocks a current flowing along the path; and deriving, by the processor, impedance characteristics of the battery while the excitation current generated from the charging current is applied to the battery.

In some embodiments, in the deriving of the impedance characteristics, the processor is configured to: acquire a voltage characteristic parameter of the battery while the excitation current generated from the charging current is applied to the battery; acquire a current characteristic parameter of the excitation current through a current detection element provided on the path; and derive the impedance characteristics of the battery based on the voltage characteristic parameter and the current characteristic parameter.

In some embodiments, in the generating of the excitation current, the processor is configured to control the on/off operation of the switch according to a pulse width modulation (PWM) method to generate the excitation current in a form of a PWM pulse in a frequency range.

In some embodiments, the voltage characteristic parameter represents a voltage value of the battery according to a frequency, and the current characteristic parameter represents a value of the excitation current according to the frequency; and in the deriving of the impedance characteristics, the processor is configured to derive the impedance characteristics of the battery according to the frequency based on the voltage characteristic parameter and the current characteristic parameter.

In some embodiments, the method further includes analyzing, by the processor, degradation of the battery by comparing an impedance value of the battery at an analysis target frequency with a reference impedance value at the analysis target frequency.

In some embodiments, the charging of the battery by the charging current is performed according to a constant current-constant voltage (CC-CV); and the generating of the excitation current and the deriving of the impedance characteristics are triggered at a time point at which a set time elapses after a CV mode is initiated.

However, effects that can be achieved through the present invention are not limited to the above-described effects and other effects that are not described may be clearly understood by those skilled in the art from the detailed descriptions.

At least some of the above and other features of the invention are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIGS. 1 and 2 are example diagrams illustrating circuits used for performing general electrochemical impedance spectroscopy (EIS), according to some embodiments of the present invention;
FIG. 3 is a block diagram illustrating an energy storage system (ESS) according to some embodiments of the present invention;
FIG. 4 is a circuit diagram illustrating an apparatus for analyzing impedance characteristics of a battery according to some embodiments of the present invention;
FIG. 5 is an example diagram illustrating a Nyquist diagram of impedance characteristics of a battery according to some embodiments of the present invention; and
FIG. 6 is a flowchart illustrating a method of analyzing impedance characteristics of a battery according to some embodiments of the present invention.

### DETAILED DESCRIPTION

Hereinafter, some embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C", "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

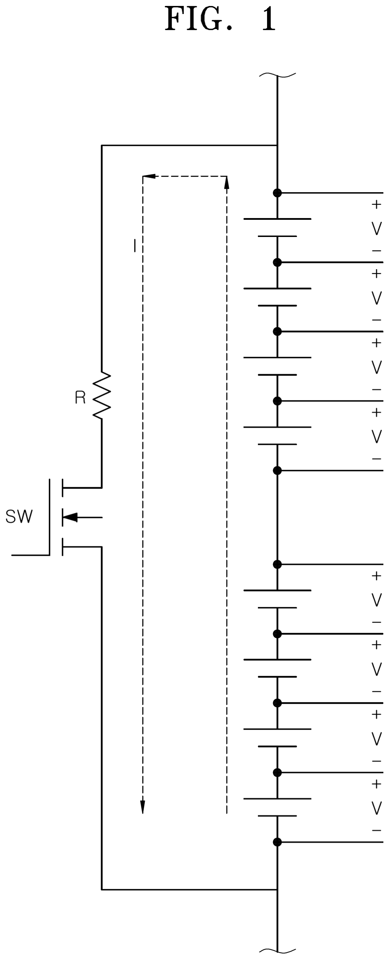

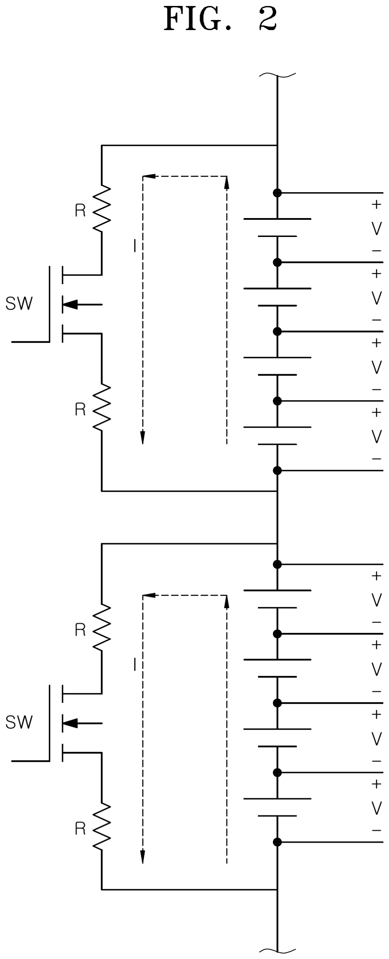

FIGS. 1 and 2 are example diagrams illustrating circuits used for performing general electrochemical impedance spectroscopy (EIS).

EIS for analyzing an impedance of a battery is widely applied and is conducted by applying an AC current or AC voltage to the battery and analyzing an impedance reaction (response) to the AC current or AC voltage. EIS analysis for batteries may be conducted as EIS analysis at a battery pack level (see, e.g., FIG. 1) or as EIS analysis at a battery module level (see, e.g., FIG. 2).

For EIS analysis at the battery pack level and EIS analysis at the battery module level, an excitation current extraction circuit connected in parallel to batteries is utilized as shown in FIGS. 1 and 2. The excitation current extraction circuit consists of a driving switch SW and a current limiting resistor R, which are electrically connected in series with one another. When the driving switch SW is turned on, a closed circuit in which a battery pack is connected to the excitation current extraction circuit is formed, and an excitation current is extracted from the battery pack. While the excitation current flows in the closed circuit, a current I and a voltage V of the battery pack are measured, and an impedance of the battery pack is derived from the measured current and voltage.

In the case of the EIS analysis method presented in FIGS. 1 and 2, because the excitation current utilized for the EIS analysis is extracted from the battery that is an impedance measurement target, there is a limit to accurately analyzing the impedance of a corresponding battery and there is also a problem of loss of available energy of the battery itself. Furthermore, heat generation in the driving switch SW and current limiting resistor R that constitute the excitation current extraction circuit and power loss in the current limiting resistor R also become factors that reduce accuracy of impedance measurement of the battery. In order to increase the accuracy of impedance analysis of the battery, a value of the excitation current should be increased, but this also entails a problem that available energy of the battery decreases in proportion to the value of the excitation current.

To this end, the EIS mechanism according to some embodiments accurately analyzes impedance characteristics of a battery without problems of a decrease in available capacity of the battery and a decrease in impedance accuracy. These issue may occur due to heat generation in peripheral circuits by performing EIS analysis using a method of generating an excitation current from a charging current for charging the battery, rather than analyzing an impedance of the battery using an excitation current extracted from the battery that is an impedance analysis target.

The apparatus for analyzing impedance characteristics of a battery (hereinafter referred to as "the apparatus") according to some embodiments may be applied to a battery device having a battery management system (BMS), such as a general battery pack in addition to an ESS. Hereinafter, in order to aid understanding of the present invention, an example in which the apparatus is applied to the ESS will be described.

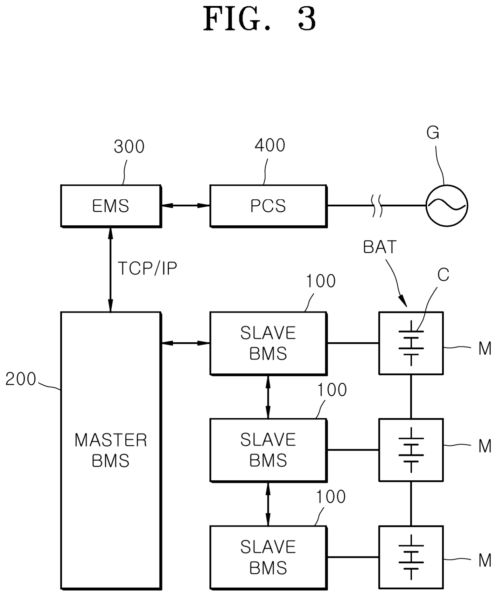

Referring to FIG. 3, the ESS according to some embodiments may include a battery BAT, a plurality of slave BMSs 100, a master BMS 200, an energy management system (EMS) 300, and a power conversion system (PCS) 400.

The battery BAT may include one or more battery racks, and when a plurality of battery racks are provided, the plurality of battery racks may be connected to each other in series, in parallel, or in a combination of series and parallel (however, only one battery rack is shown in FIG. 1 for ease of illustration). Each battery rack may include a plurality of battery modules M connected in series or in parallel, and each battery module M may include a plurality of battery cells C connected in series or in parallel. The battery BAT may be charged by power supplied from a grid G through the PCS 400, and the power charged in the battery BAT may be supplied to the grid G through the PCS 400.

The slave BMS 100 may be provided as a plurality of BMSs 100 to correspond one-to-one to a plurality of battery modules M. For example, each slave BMS 100 may monitor a state of a corresponding battery module M and operate to control the corresponding battery module M or perform a protection function on the corresponding battery module M on the basis of the monitoring result. For example, the slave BMS 100 may monitor a voltage, a current, a temperature, and a state of charge (SoC) of a battery cell C included in the battery module M. The slave BMS 100 may further perform control operations such as balancing control, temperature control, and charging/discharging control of the battery cell C on the basis of the monitoring result or perform a protection operation such as switch control of preventing over-discharging or over-charging. Each slave BMS 100 may include an analog-front-end (AFE) integrated circuit (IC) that monitors a state of the battery cell C and performs a battery cell control operation on the basis of the monitoring results, and a micro controller unit (MCU) that generates a control operation command or a protection operation command according to the state data of the battery cell C transmitted from the AFE IC and feeds the control operation command or the protection operation command back to the AFE IC, thereby causing the AFE IC to perform the control operation or the protection operation. The slave BMS 100 may correspond to a module BMS of the ESS (corresponding to a slave processor described in the appended claims of the present specification).

The master BMS 200 may perform control and protection functions of the battery rack on the basis of the state data of the battery cell C or the battery module M received from the plurality of slave BMSs 100. The master BMS may control the operation of each slave BMS 100 and may function as a master for the slave BMS 100. The master BMS may include an MCU that generates a control operation command or a protection operation command according to the state data of the battery cell C or the battery module M transmitted from each slave BMS 100 and feeds the control operation command or the protection operation command back to the slave BMS 100, thereby causing the slave BMS 100 to perform the control operation or the protection operation for each battery module M. The master BMS 200 may correspond to a rack BMS of the ESS (corresponding to a master processor 200 described in the appended claims of the present specification). The master BMS 200 and the plurality of slave BMSs 100 may be connected for communication in a daisy chain manner, and isolated serial peripheral interface (isoSPI), controller area network (CAN) communication, or the like may be used as the communication method.

Under the control of the EMS 300, the PCS 400 may function as a power conversion device that performs an AC-DC conversion, a voltage level regulation, and a frequency conversion to perform power linkage between the battery BAT and the grid G. For example, when the battery BAT is charged, the PCS 400 may convert a commercial AC voltage from the grid G into a DC voltage, and when the battery BAT is discharged, the PCS 400 may convert a DC voltage from the battery BAT into commercial AC voltage. In addition, In examples in which the ESS according to some embodiments is implemented as a frequency regulation ESS, the PCS 400 may perform a function of supplying power to the grid G by performing discharging according to a set speed adjustment rate under frequency droop control of the EMS 300 when a frequency of the power grid system falls to a preset reference value or less., When the frequency of the grid G becomes the reference value or more, the PCS 400 may perform a function of absorbing energy from the power grid system by performing charging of the battery BAT, thereby maintaining a stable frequency of the grid G.

The EMS 300 may function as a controller at a higher level than the master BMS 200 and the PCS 400 and may function as an integrated control device that monitors power usage of the grid G and power supply of the ESS in real time and controls an operation of the ESS. The EMS 300 may monitor states of the battery BAT, the master BMS 200, and the PCS 400, and control operations of the master BMS 200 and the PCS 400 on the basis of the monitoring results. Transmission control protocol/Internet protocol (TCP/IP) may be applied as a communication protocol between the EMS 300 and the master BMS 200.

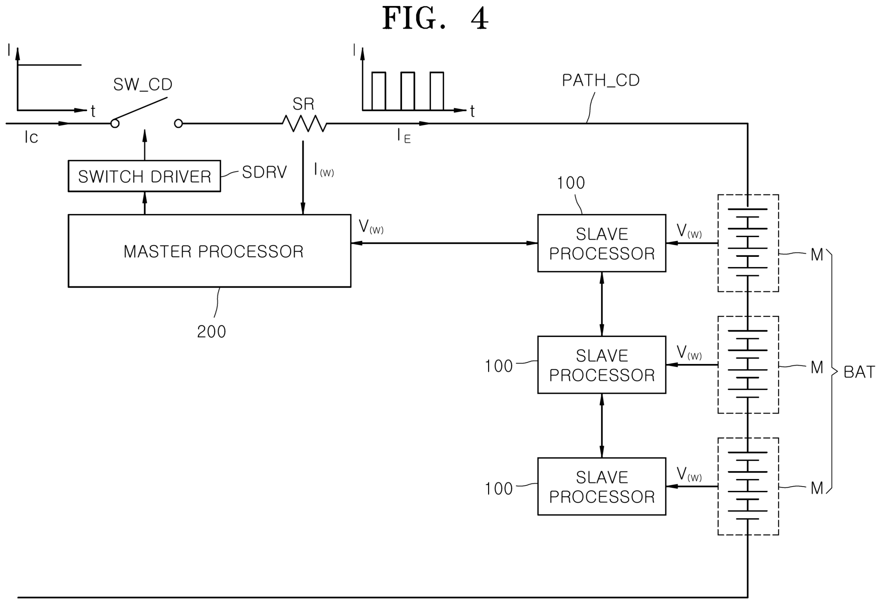

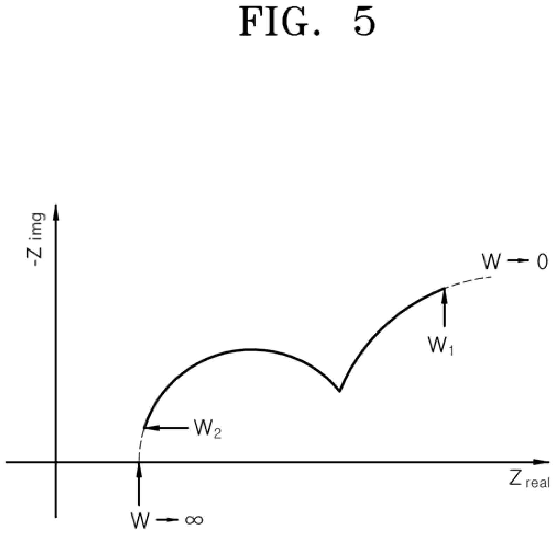

FIG. 4 is a circuit diagram illustrating an apparatus for analyzing impedance characteristics of a battery according to some embodiments of the present invention (hereinafter referred to as the apparatus). FIG. 5 is an example diagram illustrating a Nyquist diagram of impedance characteristics of a battery according to some embodiments of the present invention. The apparatus shown in FIG. 4 constitutes a part of the ESS.

As shown in FIG. 4, the apparatus may include a plurality of slave processors 100, the master processor 200, a charging/discharging path PATH_CD, a current detection element SR, a charging/discharging switch SW_CD (also simply referred to as a switch), and a switch driver SDRV. The master processor 200 and the slave processor 100 correspond to the same components as the master BMS 200 and slave BMS 100 described above, the basic operations of which have been described above, and thus a detailed description of their operations may not be repeated here.

The charging/discharging path PATH_CD may function as a path for supplying a charging current and extracting a discharging current with respect to the battery BAT. That is, when the battery BAT is charged, the charging current is supplied to the battery BAT through the charging/discharging path PATH_CD, and when the battery BAT is discharged, the discharging current is supplied to a load or the grid through the charging/discharging path PATH_CD.

The current detection element SR may correspond to a shunt resistor connected to the charging/discharging path PATH_CD to detect a current flowing through the charging/discharging path PATH_CD. The charging/discharging switch SW_CD may correspond to a relay or a transistor (e.g., a metal oxide semiconductor field effect transistor (MOSFET)) that allows or blocks a flow of a current (i.e., a flow of the charging current or the discharging current) on the charging/discharging path PATH_CD, and the switch driver SDRV may correspond to a gate driver that controls an on/off operation of the charging/discharging switch SW_CD under the control of the master processor 200. The master processor 200 may detect overcurrent through the current detection element SR and control the switch driver SDRV according to the detection result to control the on/off operation of the charging/discharging switch SW_CD. That is, the master processor 200 may operate to detect a state in which overcurrent is flowing to the battery BAT through the current detection element SR and control the switch driver SDRV to turn the charging/discharging switch SW_CD off, thereby preventing burning of the battery BAT due to the overcurrent.

The following description focuses on a configuration for performing EIS analysis using a method of generating an excitation current from a charging current for charging a battery.

The master processor 200 according to some embodiments may derive impedance characteristics of the battery by controlling the on/off operation of the charging/discharging switch SW_CD while a charging current IC for charging the battery BAT is supplied through the charging/discharging path PATH_CD and generating an excitation current IE for deriving the impedance characteristics of the battery BAT from the charging current.

For example, the master processor 200 may control the on/off operation of the charging/discharging switch SW_CD according to a pulse width modulation (PWM) method to generate an excitation current in the form of a PWM pulse, and in particular, may control the on/off operation of the charging/discharging switch SW_CD to allow the excitation current to be in a set or predefined frequency range (also referred to as a frequency range). The frequency range is a verification target of the impedance characteristics of the battery BAT and may be defined in advance as, for example, a range of 0.1 kHz to 5 kHz (ω1 to ω2 in FIG. 5). The master processor 200 may control the on-off operation of the charging/discharging switch SW_CD while changing a PWM control duty so that the excitation current has the frequency range defined above (the PWM control duty corresponding to the set or predefined frequency range may also be predefined in the master processor 200).

When the excitation current in the form of a PWM pulse in the frequency range is applied to the battery, the slave processor 100 may acquire voltage characteristic parameters of the battery and transmit the voltage characteristic parameters to the master processor 200. The master processor 200 may derive the impedance characteristics of the battery on the basis of voltage characteristic parameters of the battery acquired through the slave processor 100 and current characteristic parameters of the excitation current acquired through the current detection element SR.

Because the excitation current has the set or predefined frequency range, the voltage of the battery acquired by the slave processor 100 may also have the form of an AC voltage. Accordingly, the voltage characteristic parameter of the battery may be parameterized in the form of V_{(ω)}, which represents a voltage value of the battery according to the frequency. The current characteristic parameter of the excitation current may also be parameterized in the form of I_{(ω)}, which represents a value of the excitation current according to the frequency. Here, ω is a notation representing a frequency.

The master processor 200 may derive the impedance characteristics of the battery according to the frequency on the basis of the voltage characteristic parameters and the current characteristic parameters. The master processor 200 may derive the impedance characteristics of the battery as a ratio of the voltage characteristic parameter and the current characteristic parameter (i.e., V_{(ω)}/I_{(ω)}), and the impedance characteristics of the battery may have the form of a Nyquist diagram as shown in FIG. 5.

When the impedance characteristics of the battery in the form of the Nyquist diagram are derived, the master processor 200 may analyze degradation of the battery by comparing an impedance value of the battery at an analysis target frequency with a set or predefined reference impedance value (also referred to as a reference impedance value) at the analysis target frequency. The reference impedance value may be predefined (e.g., prestored) in the master processor 200 as the impedance value of the battery at the analysis target frequency on the basis of a state in which no degradation of the battery occurs. Accordingly, the master processor 200 derives the impedance value of the battery from the Nyquist diagram at the analysis target frequency that is an impedance value verification target. Further, when the derived impedance value of the battery is greater than or equal to the reference impedance value, the master processor 200 may determine that the degradation of the battery occurs.

The above battery impedance derivation operation is performed in a state in which the battery is charged by the charging current supplied through the charging/discharging path PATH_CD, and a constant current-constant voltage (CC-CV) method may be employed as the battery charging method. As described above, because the current control operation of generating the excitation current from the charging current by controlling the on/off operation of the charging/discharging switch SW_CD, the master processor 200 may derive the impedance characteristics of the battery in a CV mode in which the current control is possible among a CC mode and the CV mode. In such examples, in order to reduce (e.g., minimize) an influence of the battery impedance derivation operation on the charging operation of the battery, the master processor 200 may control the on/off operation of the charging/discharging switch SW_CD to generate the excitation current at a time point when a set or predefined time elapses after the CV mode is initiated, and the set or predefined time may have a time length that is, for example, greater than or equal to half of the total time during which the CV mode is performed. That is, the master processor 200 may perform the battery impedance derivation operation at the end of the CV mode, thereby reducing (e.g., minimizing) the influence of the battery impedance derivation operation on the battery charging operation.

Because the voltage characteristic parameters of the battery used in the process of deriving the impedance characteristics of the battery are acquired by the slave processor 100 and the voltage of the battery cell C constituting each battery module M may be measured by the AFE IC included in the slave processor 100, the master processor 200 may derive the impedance characteristics of the battery for each of the plurality of battery cells C using the current characteristic parameter of the excitation current and the voltage characteristic parameter acquired with respect to each of the plurality of battery cells C. Furthermore, because the voltage of the battery module M may be measured by the AFE IC included in the slave processor 100, the master processor 200 may derive the impedance characteristics of the battery for each of the plurality of battery modules M using the current characteristic parameter of the excitation current and the voltage characteristic parameters acquired with respect to the battery module M.

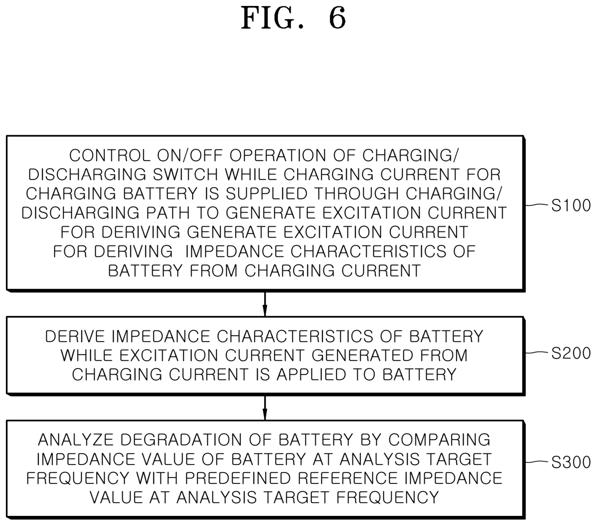

FIG. 6 is a flowchart illustrating a method of analyzing impedance characteristics of a battery according to some embodiments of the present invention. The method of analyzing impedance characteristics of a battery according to some embodiments will be described with reference to FIG. 6. Here, detailed description of parts overlapping the above-described content may not be repeated and the following description will focus on a time-series structure.

First, the master processor 200 controls the on/off operation of the charging/discharging switch SW_CD while a charging current for charging the battery is supplied through the charging/discharging path PATH_CD, thereby generating an excitation current for deriving impedance characteristics of the battery from the charging current (S100).

In operation S100, the master processor 200 controls the on/off operation of the charging/discharging switch SW_CD according to a PWM method to generate the excitation current in the form of a PWM pulse in a set or predefined frequency range.

Next, the master processor 200 derives impedance characteristics of the battery while the excitation current generated from the charging current is applied to the battery (S200).

In operation S200, the master processor 200 acquires voltage characteristic parameters of the battery while the excitation current generated from the charging current is applied to the battery, acquires current characteristic parameters of the excitation current through the current detection element SR provided on the charging/discharging path PATH_CD, and then derives impedance characteristics of the battery on the basis of the voltage characteristic parameters and the current characteristic parameters. The voltage characteristic parameter represents a voltage value of the battery according to a frequency, and the current characteristic parameter represents a value of the excitation current according to the frequency. Accordingly, in operation S200, the master processor 200 derives the impedance characteristics of the battery according to the frequency on the basis of the voltage characteristic parameters and the current characteristic parameters. The impedance characteristics of the battery may have the form of a Nyquist diagram.

In addition, in operation S200, the master processor 200 may derive the impedance characteristics of the battery for each of the plurality of battery cells C using the current characteristic parameter of the excitation current and the voltage characteristic parameter acquired for each of the plurality of battery cells C, or derive the impedance characteristics of the battery for each of the plurality of battery modules M using the current characteristic parameter of the excitation current and the voltage characteristic parameter for the battery module M.

Subsequently, the master processor 200 may analyze degradation of the battery by comparing an impedance value of the battery at an analysis target frequency with a set or predefined reference impedance value at the analysis target frequency (S300).

Operations S100 to S300 described above are triggered at a time point when a set or predefined time elapses after a CV mode of charging modes of the battery is initiated, and the set or predefined time may have a time length that is greater than or equal to half of the total time during which the CV mode is performed.

According to the present invention, by employing the method of analyzing an impedance of a battery by generating an excitation current in a specific frequency range from a charging current for charging the battery rather than analyzing the impedance of the battery using the excitation current extracted from the battery that is an impedance analysis target, the impedance characteristics of the battery can be accurately derived without reducing an available capacity of the battery or causing heat generation in the peripheral circuits.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various suitable modifications and variations can be made by a person skilled in the art to which the present disclosure belongs within the scope of the technical information of the present disclosure as defined by the claims and their equivalents, below.

## Claims

1. An apparatus for analyzing impedance characteristics of a battery, the apparatus comprising:
a switch configured to allow or block a current flowing along a path for supplying a charging current to a battery or extracting a discharging current from the battery; and
a processor configured to derive impedance characteristics of the battery using a method of generating an excitation current for deriving the impedance characteristics of the battery from the charging current by controlling an on/off operation of the switch while the charging current for charging the battery is supplied through the path.

2. The apparatus of claim 1, further comprising:
a current detection element configured to detect the current flowing along the path,
wherein the processor is configured to derive the impedance characteristics of the battery based on a voltage characteristic parameter of the battery and a current characteristic parameter of the excitation current acquired through the current detection element while the excitation current generated from the charging current is applied to the battery.

3. The apparatus of claim 2, wherein the processor is configured to control the on/off operation of the switch according to a pulse width modulation (PWM) method to generate the excitation current in a form of a PWM pulse, and
the processor is configured to control the on/off operation of the switch to allow the excitation current to be in a frequency range.

4. The apparatus of claim 3, wherein:
the voltage characteristic parameter represents a voltage value of the battery according to a frequency, and the current characteristic parameter represents a value of the excitation current according to the frequency; and
the processor is configured to derive the impedance characteristics of the battery according to the frequency based on the voltage characteristic parameter and the current characteristic parameter.

5. The apparatus of any of claims 2-4, wherein:
the processor is configured to control the charging of the battery by the charging current according to a constant current-constant voltage (CC-CV); and
the processor is configured to derive the impedance characteristics of the battery in a CV mode.

6. The apparatus of claim 5, wherein the processor is configured to control the on/off operation of the switch to generate the excitation current at a time point at which a set time elapses after the CV mode is initiated.

7. The apparatus of any of claims 2-6, wherein:
the battery comprises a plurality of battery cells; and
the processor generating the excitation current is defined as a master processor, and the apparatus further comprises:
a slave processor configured to acquire the voltage characteristic parameter for each of the plurality of battery cells and to transmit the voltage characteristic parameter to the master processor.

8. The apparatus of claim 7, wherein the master processor is configured to derive the impedance characteristics of the battery for each of the plurality of battery cells using the current characteristic parameter of the excitation current and the voltage characteristic parameter acquired for each of the plurality of battery cells.

9. The apparatus of claim 7 or claim 8, wherein:
the battery is formed by connecting a plurality of battery modules comprising the plurality of battery cells in series, in parallel, or in a combination of series and parallel;
the slave processor comprises a plurality of slave processors to correspond one-to-one to the plurality of battery modules; and
the master processor and the plurality of slave processors are connected in a daisy chain manner.

10. An energy storage system (ESS) comprising:
a battery;
a switch configured to allow or block a current flowing along a path for supplying a charging current to a battery or extracting a discharging current from the battery; and
a battery management system (BMS) configured to derive impedance characteristics of the battery using a method of generating an excitation current for deriving the impedance characteristics of the battery from the charging current by controlling an on/off operation of the switch while the charging current for charging the battery is supplied through the path.

11. A method of analyzing impedance characteristics of a battery, the method comprising:
generating, by a processor, an excitation current for deriving impedance characteristics of a battery from a charging current by controlling an on/off operation of a switch while the charging current for charging the battery is supplied through a path, wherein the path is for supplying the charging current to the battery or extracting a discharging current from the battery, and the switch allows or blocks a current flowing along the path; and
deriving, by the processor, impedance characteristics of the battery while the excitation current generated from the charging current is applied to the battery.

12. The method of claim 11, wherein, in the deriving of the impedance characteristics, the processor is configured to:
acquire a voltage characteristic parameter of the battery while the excitation current generated from the charging current is applied to the battery;
acquire a current characteristic parameter of the excitation current through a current detection element provided on the path; and
derive the impedance characteristics of the battery based on the voltage characteristic parameter and the current characteristic parameter.

13. The method of claim 12, wherein, in the generating of the excitation current, the processor is configured to control the on/off operation of the switch according to a pulse width modulation (PWM) method to generate the excitation current in a form of a PWM pulse in a frequency range,
the voltage characteristic parameter represents a voltage value of the battery according to a frequency, and the current characteristic parameter represents a value of the excitation current according to the frequency; and
in the deriving of the impedance characteristics, the processor is configured to derive the impedance characteristics of the battery according to the frequency based on the voltage characteristic parameter and the current characteristic parameter.

14. The method of claim 13, further comprising analyzing, by the processor, degradation of the battery by comparing an impedance value of the battery at an analysis target frequency with a reference impedance value at the analysis target frequency.

15. The method of any of claims 12-14, wherein:
the charging of the battery by the charging current is performed according to a constant current-constant voltage (CC-CV); and
the generating of the excitation current and the deriving of the impedance characteristics are triggered at a time point at which a set time elapses after a CV mode is initiated.
